# DEMANDE DE BREVET EUROPEEN

(11) **EP 0 926 811 A1**
(43) Date de publication de la demande: **30.06.1999**
(21) Numéro de dépôt: 98204178.2
(22) Date de dépôt: 08.12.1998
(51) Int. Cl.: H03C 3/09, H04N 5/40, H03C 1/06

(54) **Modulateur à faible couplage parasite**

(30) Priorité: 15.12.1997 FR 9715878
(71) Demandeur: Koninklijke Philips Electronics N.V., 5621 BA Eindhoven (NL)
(72) Inventeur: Klaeyle, Philippe, Société Civile S.P.I.D., 75008 Paris (FR)
(74) Mandataire: Caron, Jean

(57) **Abrégé**

La présente invention concerne un modulateur MOD qui comporte un oscillateur OSC ayant une fréquence d'oscillation Fosc, et un mélangeur MIX destiné à délivrer un signal modulé Sout à une fréquence de sortie Fout donnée.

Selon l'invention, la fréquence nominale d'oscillation Fosc est N fois supérieure à la fréquence de sortie Fout, le modulateur MOD comportant en outre un diviseur de fréquence DIV/N, destiné à recevoir le signal de sortie de l'oscillateur OSC et à délivrer au mélangeur MIX le signal porteur.

Applications : Modulation en sortie d'un décodeur de signaux de télévision numériques.

## Description

La présente invention concerne un modulateur comportant :
. un oscillateur destiné à générer un signal ayant une fréquence dite d'oscillation, et
. un mélangeur destiné à recevoir un signal modulant et un signal porteur, et à délivrer un signal modulé à une fréquence de sortie donnée.

De tels modulateurs sont couramment fabriqués dans l'industrie des circuits intégrés, pour être par exemple utilisés dans des magnétoscopes ou des décodeurs de signaux télévision numériques. La demanderesse commercialise, sous la référence TDA 8722, un tel circuit intégré. Dans ce modulateur, le signal porteur est constitué par le signal généré par l'oscillateur, et le signal modulé possède une fréquence égale à la fréquence d'oscillation, car l'oscillateur est directement relié au mélangeur. Or il a été constaté que l'oscillateur et la sortie du mélangeur interagissent par le biais de connexions à des sources d'énergie communes à ces deux éléments, d'une part, et par l'intermédiaire de phénomènes de rayonnement électromagnétique, d'autre part. Cette interaction a des effets néfastes. L'oscillateur induit dans le signal modulé un signal parasite à la fréquence d'oscillation qui est, par construction, égale à la fréquence du signal porteur. Les variations de ce signal parasite coïncident donc avec celles du signal modulé et modifient l'amplitude de celui-ci. Il s'ensuit une modification de l'enveloppe du signal modulé qui est équivalente à une altération de l'information que véhicule ledit signal.

La présente invention a pour but de remédier à cet inconvénient, en proposant un modulateur dont la structure est telle que les effets de l'interaction entre l'oscillateur et la sortie du mélangeur peuvent être aisément éliminés.

En effet, un modulateur conforme au paragraphe introductif est caractérisé selon l'invention en ce que l'oscillateur est agencé de sorte que sa fréquence nominale d'oscillation soit N fois supérieure à la fréquence de sortie, et en ce que le modulateur comporte en outre un diviseur de fréquence par N, destiné à recevoir le signal de sortie de l'oscillateur et à délivrer au mélangeur le signal porteur.

Dans un tel modulateur, le signal porteur n'est plus le signal de sortie de l'oscillateur, mais le signal de sortie du diviseur de fréquence. La fréquence du signal porteur étant différente de la fréquence d'oscillation, le signal parasite induit par l'oscillateur dans le signal modulé possède une fréquence différente de celle du signal modulé. Le signal parasite peut ainsi être aisément identifié et filtré, par exemple au moyen d'un filtre passe-bande.

Le modulateur selon l'invention permet en outre d'obtenir un signal modulé présentant une pureté spectrale améliorée par rapport à celle que présente le signal modulé généré par le modulateur connu. En effet, l'ensemble de l'oscillateur, ainsi que ses connexions avec le reste du circuit, doit être parfaitement symétrique pour qu'il puisse délivrer un signal ayant pour rapport cyclique 1/2. Cette condition de symétrie est très difficile à réaliser en pratique. Il s'ensuit que le rapport cyclique du signal de sortie de l'oscillateur ne peut être précisément égal à 1/2, ce qui induit notamment la présence dans ce signal d'un signal ayant une fréquence double de la fréquence de l'oscillation, qui est couramment appelé seconde harmonique. Dans le modulateur connu, cette seconde harmonique apparaît dans le signal modulé puisque le signal de sortie de l'oscillateur constitue le signal porteur. Dans le modulateur conforme à l'invention, le signal porteur est constitué par le signal de sortie d'un diviseur de fréquence, dont la précision du rapport cyclique peut être aisément maîtrisée. Plusieurs modes de réalisation peuvent être envisagés dans ce but.

Un mode de réalisation particulier de l'invention présente un modulateur tel que décrit ci-dessus, caractérisé en ce que, le taux N de la division de fréquence effectuée par le diviseur étant égal à 2^{P}, où P est un entier, le diviseur est constitué de P diviseurs par deux disposés en cascade, chacun d'entre eux comportant une première et une deuxième bascules mémoire dont chacune est munie d'une entrée de commande, ainsi que d'une entrée et d'une sortie de données, l'entrée de commande de la première bascule mémoire formant l'entrée du diviseur par deux et étant reliée, via une inversion, à l'entrée de commande de la deuxième bascule mémoire, la sortie de données de la deuxième bascule mémoire étant connectée, via une inversion, à l'entrée de données de la première bascule mémoire, la sortie de données de la première bascule mémoire étant connectée à l'entrée de données de la deuxième bascule mémoire, l'une des sorties de données des première et deuxième bascules mémoire formant la sortie du diviseur par deux.

Ainsi qu'exposé précédemment, un modulateur conforme à l'invention peut être avantageusement utilisé dans divers appareils tels des magnétoscopes ou des décodeurs de signaux télévision numériques. L'invention concerne donc également un appareil servant à la conversion d'informations en signaux ayant une forme compatible avec les standards télévision, comportant :
. une unité dite d'entrée destinée à assurer la réception des informations et à en extraire des signaux de deux natures différentes, l'un dit signal audio, l'autre dit signal vidéo,
. un premier et un deuxième modules de traitement respectivement destinés à une remise en forme des signaux audio et vidéo,
. un additionneur destiné à délivrer sur une sortie un signal résultant d'une superposition de signaux présents aux sorties des premier et deuxième modules de traitement, et
. un modulateur destiné à opérer une conversion de la fréquence du signal de sortie de l'additionneur vers une fréquence donnée,
appareil caractérisé en ce que le modulateur est tel que décrit plus haut, son signal modulant étant constitué par le signal de sortie de l'additionneur.

L'invention sera mieux comprise à l'aide de la description suivante, faite à titre d'exemple non-limitatif et en regard des dessins annexés, dans lesquels :
- la figure 1 est un schéma fonctionnel partiel décrivant un modulateur selon l'invention,
- la figure 2 est un diagramme spectral décrivant un signal modulé généré par un tel modulateur,
- la figure 3 est un schéma électrique décrivant un diviseur par deux inclus dans un diviseur de fréquence conforme à un mode de réalisation particulier de l'invention,
- la figure 4 est un ensemble de chronogrammes décrivant l'évolution de signaux internes à un tel diviseur par deux, et
- la figure 5 est un schéma fonctionnel partiel décrivant un appareil de conversion de signaux intégrant un modulateur selon l'invention.

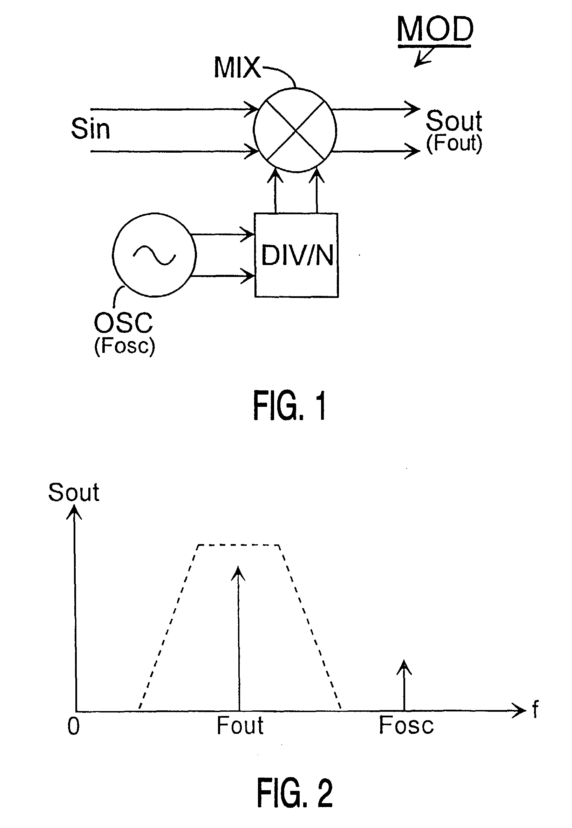

La figure 1 représente partiellement un modulateur MOD conforme à l'invention. Un tel modulateur comporte :
. un oscillateur OSC destiné à générer un signal ayant une fréquence dite d'oscillation Fosc, et
. un mélangeur MIX destiné à recevoir un signal modulant Sin et un signal porteur, et à délivrer un signal modulé Sout à une fréquence de sortie Fout donnée.

L'oscillateur est agencé de sorte que sa fréquence nominale d'oscillation Fosc soit N fois supérieure à la fréquence de sortie Fout. Ceci s'obtient en choisissant pour les limites de la plage de variations de la fréquence d'oscillation Fosc des valeurs N fois supérieures aux limites de la plage de variations de la fréquence de sortie Fout. Le modulateur MOD comporte en outre un diviseur de fréquence par N, DIV/N, destiné à recevoir le signal de sortie de l'oscillateur OSC et à délivrer au mélangeur MIX le signal porteur, dont la fréquence est alors Fosc/N.

La figure 2 est une représentation spectrale du signal de sortie Sout du modulateur MOD conforme à l'invention. Il présente à la fréquence de sortie Fout la composante principale du signal modulé, et à la fréquence d'oscillation Fosc une composante parasite induite par une interaction existant entre l'oscillateur OSC et la sortie du mélangeur MIX, interaction due à des connexions à des sources d'énergie communes à ces deux éléments, d'une part, et à des phénomènes de rayonnement électro-magnétique, d'autre part. La fréquence du signal porteur, qui est la fréquence de sortie Fout, étant N fois inférieure à la fréquence d'oscillation Fosc, la composante parasite induite par l'oscillateur OSC est distincte de la composante principale du signal modulé Sout, et peut être aisément filtrée en sortie du modulateur MOD, par exemple au moyen d'un filtre passe-bande dont une courbe de réponse a été représentée sous forme de traits pointillés sur la figure. Un tel filtrage n'est pas possible pour le signal de sortie du modulateur connu, pour lequel la fréquence du signal porteur, et donc celle du signal de sortie Sout, est égale à la fréquence d'oscillation Fosc (Fout=Fosc), ce qui signifie que les composantes parasite et principale du signal modulé Sout sont confondues.

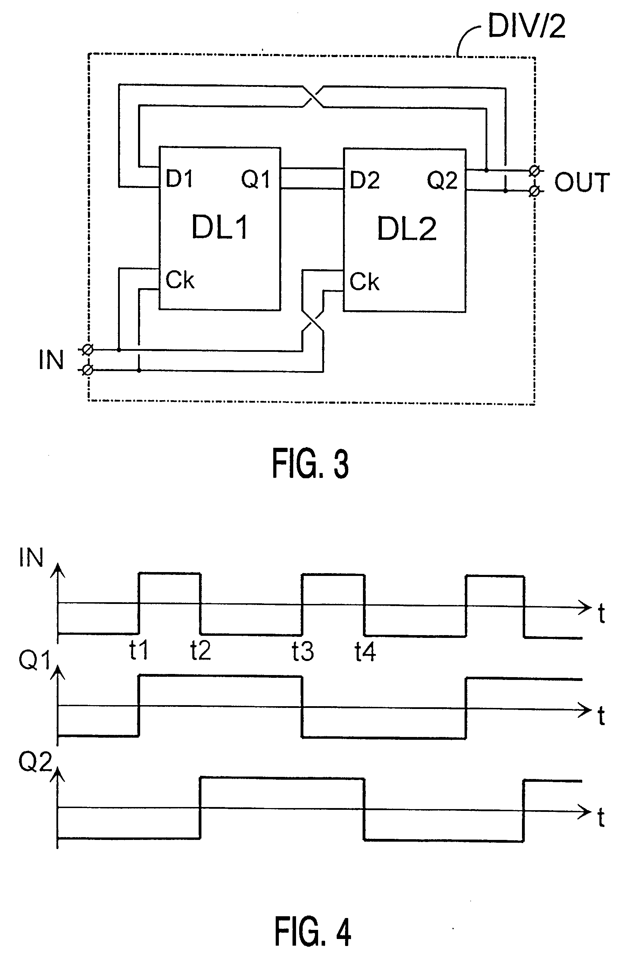

La figure 3 représente un diviseur par deux DIV/2 inclus dans un diviseur par N, DIV/N, conforme à un mode de réalisation particulier de l'invention. Si le taux N de la division de fréquence effectuée par le diviseur DIV/N est choisi égal à 2^{P}, où P est un entier, le diviseur DIV/N sera avantageusement constitué de P diviseurs par deux DIV/2 disposés en cascade. Le taux de division N peut être choisi égal à 2, auquel cas le diviseur DIV/2 représenté sur la figure constitue à lui seul le diviseur de fréquence DIV/N représenté à la figure 1. Le diviseur par deux DIV/2 comporte une première et une deuxième bascules mémoire, DL1 et DL2, dont chacune est munie d'une entrée de commande Ck, ainsi que d'une entrée et d'une sortie de données, D1, Q1 et D2, Q2. L'entrée de commande Ck de la première bascule mémoire DL1 forme l'entrée IN du diviseur par deux DIV/2 et est reliée, via une inversion, à l'entrée de commande Ck de la deuxième bascule mémoire DL2. La sortie de données Q2 de la deuxième bascule mémoire DL2 est connectée, via une inversion, à l'entrée de données D1 de la première bascule mémoire DL1. La sortie de données Q1 de la première bascule mémoire DL1 est connectée à l'entrée de données D2 de la deuxième bascule mémoire DL2. La sortie de données Q2 de la deuxième bascule mémoire DL2 forme la sortie OUT du diviseur par deux DIV/2.

La figure 4 est un ensemble de chronogrammes destiné à illustrer le fonctionnement d'un tel diviseur de fréquence. Ces chronogrammes représentent l'évolution de signaux présents aux sorties de données Q1 et Q2 des première et deuxième bascules mémoire DL1 et DL2, en relation avec des variations d'un signal présent à l'entrée IN du diviseur par deux DIV/2. Si l'on choisit par exemple un état initial dans lequel le signal présent à la sortie Q2 de la deuxième bascule mémoire DL2 est négatif lorsque le signal présent à l'entrée IN du diviseur DIV/2 est négatif, cela signifie que le signal présent à l'entrée D1 de la première bascule mémoire DL1 est positif. Lorsque, à un instant t1, le signal d'entrée du diviseur DIV/2 devient positif, la première bascule mémoire DL1 duplique, sur sa sortie de données Q1, l'état positif appliqué à son entrée de données D1. Cet état positif est alors transmis à l'entrée de données D2 de la deuxième bascule mémoire DL2. Lorsque, à un instant t2, le signal d'entrée du diviseur DIV/2 devient négatif, la deuxième bascule mémoire DL2 duplique, sur sa sortie de données Q2, l'état positif appliqué à son entrée de données D2, ce qui signifie que le signal présent à l'entrée D1 de la première bascule mémoire DL1 devient négatif. Selon un raisonnement analogue à celui développé ci-dessus, lorsque, à un instant t3, le signal d'entrée du diviseur DIV/2 redevient positif, le signal présent à la sortie Q1 de la première bascule mémoire DL1 devient négatif et est transmis à l'entrée de données D2 de la deuxième bascule mémoire DL2, et lorsque, à un instant t4, le signal d'entrée du diviseur DIV/2 redevient négatif, le signal présent à la sortie Q2 de la deuxième bascule mémoire DL2 redevient négatif, et un nouveau cycle peut débuter.

Afin de mieux illustrer les avantages que présente un tel diviseur par deux, le rapport cyclique du signal présent à l'entrée IN du diviseur par deux DIV/2, qui est égal à (t2-t1)/(t3-t1), a été volontairement choisi différent de 1/2. Si un signal de cette forme était directement envoyé au mélangeur, comme cela peut être le cas dans le modulateur connu car le rapport cyclique du signal de sortie de l'oscillateur dépend directement de la symétrie de celui-ci, symétrie qui est très difficile à maîtriser parfaitement, il s'ensuivrait l'apparition dans le signal modulé d'harmoniques paires, et en particulier d'une seconde harmonique ayant une fréquence double de la fréquence d'oscillation, provoquant une dégradation de la pureté spectrale du signal modulé. Dans le modulateur conforme à l'invention, c'est le signal de sortie du diviseur de fréquence qui constitue le signal porteur. Il apparaît clairement des chronogrammes présentés ci-dessus que le rapport cyclique du signal de sortie d'un tel diviseur de fréquence est aisément contrôlable, notamment grâce à la mise en oeuvre d'une structure bouclée du type de celle décrite par la figure 3. La pureté spectrale du signal modulé ne risque donc plus d'être dégradée du fait d'une dissymétrie quasi-inévitable de l'oscillateur, le diviseur de fréquence rétablissant de lui-même un rapport cyclique précisément égal à 1/2 pour son signal de sortie.

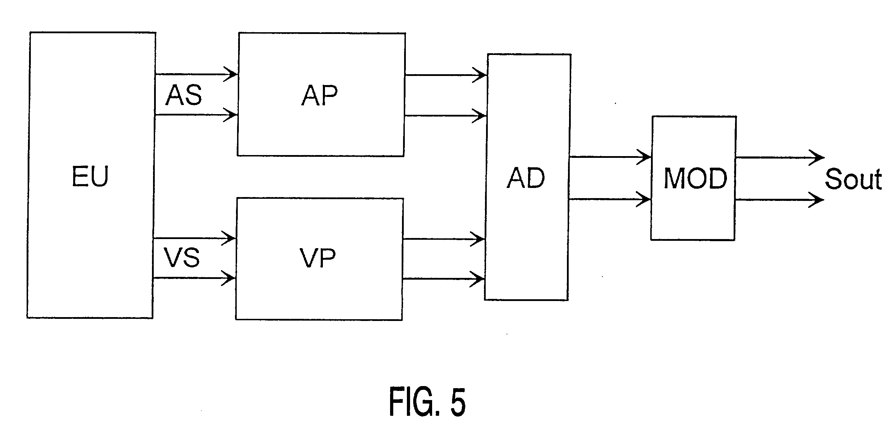

La figure 5 décrit très schématiquement un appareil servant à la conversion d'informations en signaux ayant une forme compatible avec les standards télévision, comportant :
. une unité EU dite d'entrée destinée à assurer la réception des informations et à en extraire des signaux AS et VS de deux natures différentes, l'un dit signal audio, l'autre dit signal vidéo,
. un premier et un deuxième modules de traitement, AP et VP, respectivement destinés à une remise en forme des signaux audio et vidéo AS et VS,
. un additionneur AD destiné à délivrer sur une sortie un signal résultant d'une superposition de signaux présents aux sorties des premier et deuxième modules de traitement AP et VP, et
. un modulateur MOD permettant la conversion de la fréquence du signal de sortie de l'additionneur vers une fréquence donnée, son signal modulant étant constitué par le signal de sortie de l'additionneur AD.

La structure décrite ci-dessus constitue une architecture basique pour des unités de réception et de conversion mises en oeuvre dans des magnétoscopes ou des récepteurs de signaux de télévision numériques. Si l'appareil est destiné à la réception de tels signaux numériques, l'unité d'entrée EU comportera de préférence une unité de décryptage et de démultiplexage du signal reçu, générant ainsi les signaux audio et vidéo AS et VS sous forme compressée, par exemple selon une norme MPEG, qui seront ensuite décompressés puis convertis en analogique au sein des unités de traitement AP et VP, avant d'être recombinés par l'additionneur AD. L'unité de traitement AP du signal audio AS pourra avantageusement réaliser une modulation, en amplitude ou en fréquence, dudit signal audio AS. La modulation opérée par le modulateur MOD selon l'invention permet de recréer un signal conforme aux standards de télévision classiques, sans pour autant altérer l'information véhiculée par le signal, ni dégrader sa pureté spectrale.

## Revendications

1. Modulateur comportant :
. un oscillateur destiné à générer un signal ayant une fréquence dite d'oscillation, et
. un mélangeur destiné à recevoir un signal modulant et un signal porteur, et à délivrer un signal modulé à une fréquence de sortie donnée,
caractérisé en ce que l'oscillateur est agencé de sorte que sa fréquence nominale d'oscillation soit N fois supérieure à la fréquence de sortie, et en ce que le modulateur comporte en outre un diviseur de fréquence par N, destiné à recevoir le signal de sortie de l'oscillateur et à délivrer au mélangeur le signal porteur.

2. Modulateur selon la revendication 1, caractérisé en ce que, le taux N de la division de fréquence effectuée par le diviseur étant égal à 2^{P}, où P est un entier, le diviseur est constitué de P diviseurs par deux disposés en cascade, chacun d'entre eux comportant une première et une deuxième bascules mémoire dont chacune est munie d'une entrée de commande, ainsi que d'une entrée et d'une sortie de données, l'entrée de commande de la première bascule mémoire formant l'entrée du diviseur par deux et étant reliée, via une inversion, à l'entrée de commande de la deuxième bascule mémoire, la sortie de données de la deuxième bascule mémoire étant connectée, via une inversion, à l'entrée de données de la première bascule mémoire, la sortie de données de la première bascule mémoire étant connectée à l'entrée de données de la deuxième bascule mémoire, l'une des sorties de données des première et deuxième bascules mémoire formant la sortie du diviseur par deux.

3. Appareil servant à la conversion d'informations en signaux ayant une forme compatible avec les standards télévision, comportant :
. une unité dite d'entrée destinée à assurer la réception des informations et à en extraire des signaux de deux natures différentes, l'un dit signal audio, l'autre dit signal vidéo,
. un premier et un deuxième modules de traitement respectivement destinés à une remise en forme des signaux audio et vidéo,
. un additionneur destiné à délivrer sur une sortie un signal résultant d'une superposition de signaux présents aux sorties des premier et deuxième modules de traitement, et
. un modulateur destiné à opérer une conversion de la fréquence du signal de sortie de l'additionneur vers une fréquence donnée,
appareil caractérisé en ce que le modulateur est conforme à la revendication 1, son signal modulant étant constitué par le signal de sortie de l'additionneur.
